# EUROPÄISCHE PATENTSCHRIFT

(11) **EP 3 523 684 B1**
(45) Veröffentlichungstag und Bekanntmachung des Hinweises auf die Patenterteilung: **27.10.2021**
(21) Anmeldenummer: 17777854.5
(22) Anmeldetag: 25.09.2017
(51) Int. Cl.: G02B 5/08, G21K 1/06

(54) **MULTILAYER-SPIEGEL ZUR REFLEXION VON EUV-STRAHLUNG UND VERFAHREN ZU DESSEN HERSTELLUNG**
MULTI-LAYER MIRROR FOR REFLECTING EUV RADIATION, AND METHOD FOR PRODUCING THE SAME
MIROIR MULTICOUCHE CONÇU POUR RÉFLÉCHIR LE RAYONNEMENT UVE ET SON PROCÉDÉ DE PRODUCTION

(30) Priorität: 06.10.2016 DE 102016118940
(43) Veröffentlichungstag der Anmeldung: 14.08.2019
(73) Patentinhaber: Fraunhofer-Gesellschaft zur Förderung der angewandten Forschung e.V., 80686 München (DE)
(72) Erfinder: NAUJOK, Philipp, 07751 Jena (DE); YULIN, Sergiy, 07745 Jena (DE); KAISER, Norbert, 07745 Jena (DE)
(74) Vertreter: Epping - Hermann - Fischer
(86) Internationale Anmeldenummer: PCT/EP2017/074231
(87) Internationale Veröffentlichungsnummer: WO 2018/065251

(56) Entgegenhaltungen:
- DE-A1-102006 046 000
- IGOR A. MAKHOTKIN ET AL: "Short period La/B and LaN/B multilayer mirrors for ~68 nm wavelength", OPTICS EXPRESS, Bd. 21, Nr. 24, 2. Dezember 2013 (2013-12-02), Seite 29894, XP055432474, ISSN: 2161-2072, DOI: 10.1364/OE.21.029894 in der Anmeldung erwähnt

## Beschreibung

Die Erfindung betrifft einen Multilayer-Spiegel, der zur Reflexion von extrem ultravioletter Strahlung (EUV-Strahlung) im Spektralbereich zwischen 6 nm und 10 nm vorgesehen ist, und ein Verfahren zur Herstellung des Multilayer-Spiegels.

In diesem Wellenlängenbereich ist die Wellenlänge um 6,7 nm von besonderer Bedeutung, weil Strahlung dieser Wellenlänge in einer nächsten Generation der EUV-Lithographie (BEUVL, Beyond Extreme Ultraviolet Lithography) eingesetzt werden könnte.

Multilayer-Spiegel für den EUV-Spektralbereich weisen eine in der Regel periodische Schichtenfolge aus einer Vielzahl von Dünnschichtpaaren auf. Ein Dünnschichtpaar enthält im Allgemeinen zwei Schichten aus verschiedenen Materialien, die in dem zur Verwendung des Bauelements vorgesehenen Wellenlängenbereich einen möglichst großen Unterschied in ihren optischen Konstanten aufweisen sollten. Zumindest eines dieser Materialien sollte bei der vorgesehenen Wellenlänge eine möglichst geringe Absorption aufweisen. Die Auswahl der Materialien für die Schichtenfolge ist daher vor allem von der Wellenlänge, bei der das optische Bauelement verwendet werden soll, abhängig. Im EUV-Spektralbereich gibt es daher für jeweils einen bestimmten, meist nur wenige Nanometer breiten Wellenlängenbereich eine optimale Materialpaarung, welche aufgrund des optischen Kontrastes der Schichtmaterialien eine hohe Reflexion garantiert.

Zur Realisierung optischer System im EUV-Spektralbereich besteht ein Bedarf für Spiegel, die sich durch eine möglichst hohe Reflexion auszeichnen. Dies gilt insbesondere für Anwendungen, bei denen eine mehrfache Reflexion an verschiedenen Spiegeln erfolgt, da die Reflexion des gesamten optischen Systems in diesem Fall exponentiell mit der Anzahl der Spiegel abnimmt. Bei einer Anordnung aus mehreren Spiegeln hat deshalb bereits eine geringfügige Verbesserung der Reflexion eines Einzelspiegels einen erheblichen Einfluss auf die Gesamtreflexion des optischen Systems.

In der Druckschrift US 2011/0194087 A1 werden Multilayer-Spiegel für den Wellenlängenbereich von 5 nm bis 12 nm beschrieben, die Wechselschichtsysteme aus ersten Schichten und zweiten Schichten sind, wobei die ersten Schichten Lanthan oder Thorium oder ein Nitrid oder Carbid dieser Materialien aufweisen, und wobei die zweiten Schichten Bor (B) oder Borcarbid (B₄C) aufweisen.

DC-Magnetronsputtern hat sich als das Verfahren herausgestellt, das in der Lage ist, Multilayer-Spiegel herzustellen, die den hohen industriellen Anforderungen für die EUV-Lithographie, insbesondere hinsichtlich der Reproduzierbarkeit der Beschichtung und einer exakten Schichtdickenverteilung, genügen. Beim DC-Magnetronsputtern wird zwischen einem Target aus dem Schichtmaterial und dem zu beschichtenden Substrat eine Gleichspannung (typischerweise von einigen hundert Volt) angelegt, es wird daher auch Gleichspannungssputtern genannt. Das Target bildet die negative und das Substrat die positiv geladene Elektrode.

Durch Stoßionisation der Atome des eingesetzten Inertgases (z. B. Argon) bildet sich im Gasraum ein Plasma (ein Argon-Niederdruckplasma), dessen Bestandteile negativ geladene Elektronen und positiv geladene Gasionen, wie Ar+, durch die angelegte Gleichspannung in Richtung des Substrats bzw. des Targets beschleunigt werden. Es trifft nun ein dauerhafter Strom aus positiven Ionen auf das Target; daher auch der englischsprachige Name des Verfahrens direct current sputtering, dt. Gleichstrom- bzw. DC-Sputtern. Beim Aufprall auf das Target werden durch Impulsübertrag Teilchen aus dem Target herausgeschlagen, die sich vom Target weg in Richtung des Substrats bewegen und sich dort als dünne Schicht niederschlagen.

Beim DC-Magnetronsputtern wird hinter dem Target ein zusätzliches Magnetfeld erzeugt. Durch die Überlagerung von elektrischem Feld und magnetischem Feld bewegen sich die Ladungsträger nicht mehr parallel zu den elektrischen Feldlinien, sondern werden auf eine Spiralbahn abgelenkt. Dadurch wird deren Weg verlängert und die Zahl der Stöße pro Elektron erhöht sich. Das effektiv höhere Ionisierungsvermögen der Elektronen führt zu einer Erhöhung der Edelgasionenzahl und somit auch der Sputterrate.

Wesentlicher Nachteil dieses Verfahrens ist, dass es nur für elektrisch leitfähige Targetmaterialien anwendbar ist. Bei elektrisch isolierenden Materialien würden sich durch die ständige Versorgung mit neuen Ladungsträgern sowohl Target als auch das Substrat elektrisch aufladen, damit das Gleichspannungsfeld kompensieren und den Sputterprozess behindern, da nachfolgende Ionen elektrisch abgestoßen würden.

Während sich Borcarbid (B₄C) hervorragend DC-Sputtern lässt, kann für reines Bor aufgrund seiner viel zu geringen elektrischen Leitfähigkeit DC-Sputtern nicht verwendet werden. Somit müssen hier andere, deutlich aufwändigere Verfahren zur Beschichtung eingesetzt werden. In der Druckschrift I. A. Makhotkin et al., "Short period La/B and LaN/B multilayer mirrors for ~6.8 nm wavelength", Optics Express 21 (24), 2013, S. 29894- 299904, wird vorgeschlagen, das zu sputternde Bor-Target auf über 400 °C zu erhitzen, was dessen Leitfähigkeit hinreichend erhöht. Dies geht jedoch mit erhöhtem Aufwand einher und kann zur unerwünschten Erhitzung des zu beschichtenden Substrates führen. Alternativ kann für ein nichtleitendes Material die Technik des Hochfrequenzsputterns angewandt werden, die allerdings deutlich instabiler als DC-Sputtern ist und Probleme hat, den industriellen Anforderungen zu genügen.

Eine zu lösende Aufgabe besteht somit darin, einen Multilayer-Spiegel zur Reflexion von EUV-Strahlung im Spektralbereich zwischen 6 nm und 10 nm anzugeben, der sich durch eine hohe Reflexion auszeichnet und mit vergleichsweise geringem Aufwand, hoher Genauigkeit und guter Reproduzierbarkeit, herstellbar ist. Weiterhin soll ein geeignetes Verfahren zur Herstellung des Multilayer-Spiegels angegeben werden.

Diese Aufgaben werden durch einen Multilayer-Spiegel und ein Verfahren zu dessen Herstellung gemäß den unabhängigen Patentansprüchen gelöst. Vorteilhafte Ausgestaltungen und Weiterbildungen der Erfindung sind Gegenstand der abhängigen Ansprüche.

Der hier beschriebene Multilayer-Spiegel ist zur Reflexion von EUV-Strahlung im Spektralbereich zwischen 6 nm und 10 nm, vorzugsweise zwischen 6 nm und 7 nm, insbesondere bei etwa 6,7 nm, vorgesehen. Der Multilayer-Spiegel umfasst gemäß zumindest einer Ausführungsform eine Schichtenfolge mit einer Vielzahl von abwechselnden ersten Schichten und zweiten Schichten. Die ersten Schichten weisen Lanthan oder eine Lanthanverbindung auf und die zweiten Schichten weisen Bor auf. Die zweiten Schichten sind vorteilhaft mit Kohlenstoff dotiert. "Mit Kohlenstoff dotiert" bedeutet insbesondere, dass in dem Schichtmaterial Bor Fremdatome aus Kohlenstoff enthalten sind, wobei die Konzentration der Kohlenstoffatome aber geringer ist als in der binären chemischen Verbindung aus Bor und Kohlenstoff, d.h. in Borcarbid (B₄C). Insbesondere beträgt der Stoffmengenanteil von Kohlenstoff in den zweiten Schichten nicht mehr als 10 %. Unter dem "Stoffmengenanteil" ist das Verhältnis der Anzahl der Kohlenstoffatome zur Gesamtzahl der Bor- und Kohlenstoffatome in dem Material der zweiten Schichten zu verstehen. Diese an sich dimensionslose Größe im Wertebereich zwischen 0 und 1 (d.h. zwischen 0 % und 100 %) wird teilweise auch in Atomprozent (abgekürzt at%) angegeben.

Die erreichbare Reflektivität ist umso höher, je geringer der Stoffmengenanteil von Kohlenstoff ist. Bevorzugt beträgt der Stoffmengenanteil von Kohlenstoff in den zweiten Schichten nur 5 % oder weniger, besonders bevorzugt nur 3 % oder weniger. Beispielsweise kann der Stoffmengenanteil von Kohlenstoff etwa 2 % betragen. Anders ausgedrückt weisen die zweiten Schichten B₁₋ₓCₓ mit x ≤ 0,1 auf, bevorzugt mit x ≤ 0,05 und besonders bevorzugt mit x ≤ 0,03.

Es hat sich herausgestellt, dass bereits eine im Vergleich zu Borcarbid (B₄C) geringe Kohlenstoffkonzentration in dem Schichtmaterial Bor ausreichend ist, eine ausreichende elektrische Leitfähigkeit zu erzeugen, die eine Herstellung der zweiten Schichten mittels DC-Magnetronsputtern ermöglicht. Dies ist vorteilhaft, da die Schichten mittels DC-Magnetronsputtern mit hoher Schichtdickenpräzision und sehr guter Reproduzierbarkeit hergestellt werden können. Im Vergleich zu Multilayer-Spiegeln, die auf der Materialkombination einer Lanthanverbindung und Borcarbid (B₄C) basieren, kann mit der hier vorgeschlagenen Materialkombination von Lanthan oder einer Lanthanverbindung mit Kohlenstoff-dotiertem Bor außerdem eine höhere Reflektivität erzielt werden. Die Borschichten mit dem sehr geringen Kohlenstoffanteil vereinen daher die Vorteile von reinen Borschichten, die sich in der Materialpaarung mit Lanthan oder einer Lanthanverbindung durch eine besonders hohe Reflektivität auszeichnen, mit denen von B₄C-Schichten, die vorteilhaft mit DC-Magnetronsputtern herstellbar sind.

Die zweiten Schichten aus Bor sind vorteilhaft über ihre gesamte Schichtdicke mit Kohlenstoff dotiert. Die Fremdatome aus Kohlenstoff liegen somit nicht nur im Grenzflächenbereich der zweiten Schichten vor, sondern sind über deren gesamte Schichtdicke verteilt. Vorzugsweise liegt eine im Wesentlichen homogene Verteilung der Fremdatome aus Kohlenstoff in den zweiten Schichten vor.

Die ersten Schichten in der Schichtenfolge aus den abwechselnden ersten Schichten und zweiten Schichten können insbesondere Lanthan, Lanthanoxid, Lanthancarbid oder Lanthannitrid aufweisen. Mit diesen Materialien lässt sich in Kombination mit den zweiten Schichten aus Kohlenstoff-dotiertem Bor eine hohe Reflektivität erzielen.

Die ersten Schichten und die zweiten Schichten des Multilayer-Spiegels weisen vorzugsweise jeweils eine Schichtdicke zwischen etwa 1 nm und etwa 3 nm auf.

Die Schichtenfolge weist bevorzugt zwischen 100 und 400 Schichtpaare aus jeweils einer der ersten Schichten und einer der zweiten Schichten auf. In dem für den hier beschriebenen Multilayer-Spiegel relevanten Wellenlängenbereich von etwa 6 nm bis 10 nm wird kann einer derart hohen Anzahl von Schichtpaaren vorteilhaft eine hohe Reflektivität erzielt werden.

Bei einer vorteilhaften Ausgestaltung des Multilayer-Spiegels sind an Grenzflächen zwischen den ersten Schichten und den zweiten Schichten dünne Barriereschichten angeordnet, die Borcarbid (B₄C) oder Kohlenstoff (C) aufweisen und nicht mehr als 1,0 nm dick sind. Bevorzugt sind die Barriereschichten zwischen 0,1 nm und 1,0 nm dick. Die Barriereschichten können vorteilhaft sein, um eine Interdiffusion an Grenzflächen zwischen den ersten Schichten und den zweiten Schichten zu minimieren. Eine Grenzflächenverbreitung durch Interdiffusion, insbesondere bei hohen Temperaturen, könnte ansonsten die Reflektivität des Multilayer-Spiegels beeinträchtigen. Durch das Einfügen der Barriereschichten zwischen den ersten Schichten und den zweiten Schichten kann somit die thermische Stabilität des Multilayer-Spiegels insbesondere für den Einsatz bei hohen Betriebstemperaturen, beispielsweise in der Umgebung einer EUV-Strahlungsquelle, verbessert werden.

Die Barriereschichten können an allen Grenzflächen zwischen den ersten Schichten und den zweiten Schichten angeordnet sein, unabhängig davon, ob in Wachstumsrichtung eine erste Schicht auf eine zweite Schicht oder umgekehrt eine zweite Schicht auf eine erste Schicht folgt. Alternativ kann aber auch vorgesehen sein, dass die Barriereschichten entweder nur an den Grenzflächen, an denen in Wachstumsrichtung eine erste Schicht auf eine zweite Schicht folgt, oder an den Grenzflächen, an denen in Wachstumsrichtung eine zweite Schicht auf eine erste Schicht folgt, eingefügt werden.

Die Schichtenfolge kann insbesondere eine periodische Schichtenfolge sein, bei dem die Schichtpaare jeweils die gleiche Dicke (Periodendicke) aufweisen. Die Periodendicke ist die Summe der Dicken einer ersten Schicht und einer zweiten Schicht, zuzüglich der gegebenenfalls zwischen den ersten Schichten und zweiten Schichten angeordneten Barriereschichten. Der Spiegel kann insbesondere für die Verwendung unter nahezu senkrechtem Strahlungseinfall vorgesehen sein, wobei in diesem Fall die Periodendicke in etwa die Hälfte der Wellenlänge beträgt. Vorzugsweise beträgt die Periodendicke zwischen etwa 3 nm und etwa 4 nm.

Bei einem Verfahren zur Herstellung des Multilayer-Spiegels für den EUV-Spektralbereich werden abwechselnd erste Schichten, die Lanthan oder eine Lanthanverbindung aufweisen, und zweite Schichten, die Bor aufweisen, abgeschieden, wobei die zweiten Schichten mit Kohlenstoff dotiert sind, und wobei der Stoffmengenanteil von Kohlenstoff in den zweiten Schichten 10 % oder weniger beträgt. Bei dem Verfahren werden die ersten Schichten und die zweiten Schichten insbesondere durch DC-Magnetronsputtern abgeschieden, wodurch sich die bereits zuvor erwähnten Vorteile einer hohen Schichtdickengenauigkeit und einer guten Reproduzierbarkeit ergeben.

Bei der Abscheidung der zweiten Schichten mittels DC-Magnetronsputtern wird vorteilhaft ein Sputtertarget verwendet, das mit Kohlenstoff dotiertes Bor aufweist. Das Sputtertarget weist vorteilhaft einen Stoffmengenanteil von Kohlenstoff auf, der im Wesentlichen gleich dem Stoffmengenanteil in den abzuscheidenden zweiten Schichten ist. Der Stoffmengenanteil von Kohlenstoff in dem Sputtertarget kann insbesondere 10 % oder weniger, bevorzugt 5 % oder weniger, besonders bevorzugt 3 % oder weniger betragen.

Die Kohlenstoffdotierung in den zweiten Schichten erfolgt aufgrund der Verwendung eines Sputtertargets, das mit Kohlenstoff dotiertes Bor aufweist, unmittelbar bei der Herstellung der zweiten Schichten, wobei die Fremdatome aus Kohlenstoff in den gesamten zweiten Schichten verteilt werden.

Weitere vorteilhafte Ausgestaltung des Verfahrens ergeben sich aus der vorherigen Beschreibung des Multilayer-Spiegels und umgekehrt.

Die Erfindung wird im Folgenden anhand von Ausführungsbeispielen im Zusammenhang mit den Figuren 1 bis 4 näher erläutert.

Es zeigen:
- Figur 1: eine schematische Darstellung eines Multilayer-Spiegels für EUV-Strahlung gemäß einem Ausführungsbeispiel,
- Figur 2: eine schematische Darstellung eines Verfahrens zur Herstellung des Multilayer-Spiegels für EUV-Strahlung gemäß einem Ausführungsbeispiel,
- Figur 3: eine schematische Darstellung eines Multilayer-Spiegels für EUV-Strahlung gemäß einem weiteren Ausführungsbeispiel, und
- Figur 4: eine graphische Darstellung der Reflexion von Multilayer-Spiegeln für EUV-Strahlung gemäß drei verschiedenen Ausführungsbeispielen und einem Vergleichsbeispiel.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

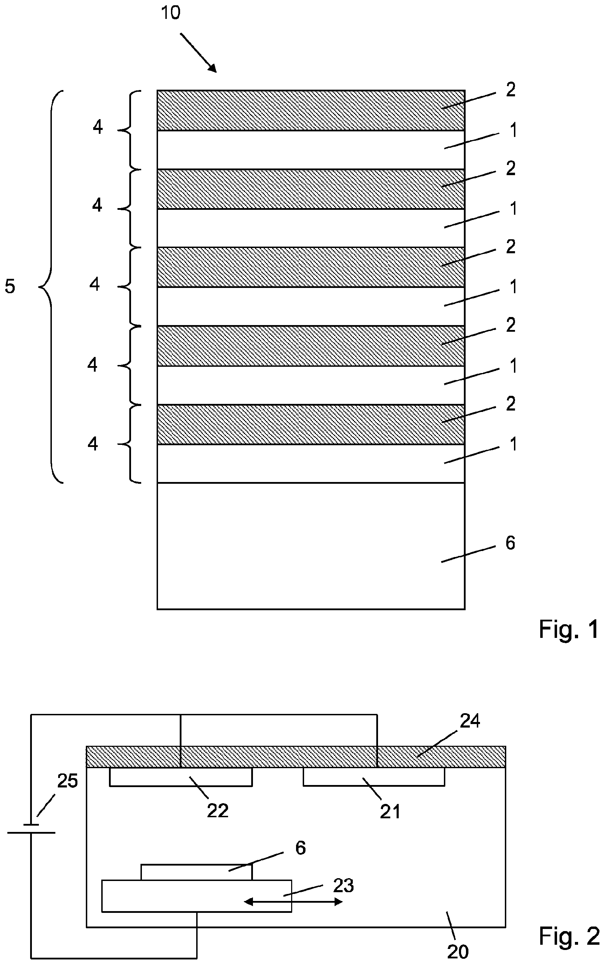

Der in Figur 1 schematisch im Querschnitt dargestellte Multilayer-Spiegel 10 für EUV-Strahlung weist eine Schichtenfolge 5 mit einer Vielzahl von abwechselnden ersten Schichten 1 und zweiten Schichten 2 auf. Die Schichtenfolge 5 ist auf ein Substrat 6 aufgebracht, dass abhängig von der Anwendung ein ebenes Substrat oder ein gekrümmtes Substrat sein kann. Zur Erzielung einer möglichst hohen Reflektivität wird vorzugsweise ein Substrat 6 mit einer geringen Oberflächenrauheit verwendet. Das Substrat 6 kann beispielsweise Silizium oder eine Glaskeramik aufweisen. Eine erste Schicht 1 und eine zweite Schicht 2 bilden jeweils ein Schichtpaar 4. Zur Vereinfachung der Darstellung sind in Figur 1 nur fünf Schichtpaare 4 dargestellt, wobei die Schichtenfolge 5 vorzugsweise aber zwischen etwa 100 und etwa 400 Schichtpaaren 4 aufweist, um eine möglichst hohe Reflexion zu erzielen. Beispielsweise kann der Multilayer-Spiegel 10 etwa 250 Schichtpaare 4 aufweisen.

Die Schichtenfolge 5 kann insbesondere eine periodische Schichtenfolge sein, bei der die Schichtpaare 4 gleich aufgebaut sind und die gleichen Schichtdicken aufweisen. Die Summe aus der Dicke einer ersten Schicht 1 und einer zweiten Schicht 2 ist in diesem Fall die Periodendicke, die vorzugsweise zwischen etwa 3 nm und etwa 4 nm beträgt. Bei einem für senkrechten Strahlungseinfall optimierten Multilayer-Spiegel 10 beträgt die Periodendicke in etwa die Hälfte der Wellenlänge des Reflexionsmaximums. Für einen Spiegel mit einem Reflexionsmaximum bei der Wellenlänge λ = 6,7 nm kann die Periodendicke zum Beispiel etwa 3,4 nm betragen.

Die ersten Schichten 1 der Schichtpaare 4 weisen Lanthan (La) oder eine Lanthanverbindung auf oder bestehen daraus. Insbesondere können die ersten Schichten ein Lanthannitrid, ein Lanthanoxid oder ein Lanthancarbid aufweisen oder daraus bestehen. Die zweiten Schichten 2 der Schichtpaare 4 weisen Bor (B) und zusätzlich Kohlenstoff (C) in geringer Konzentration auf. Hierbei beträgt der Stoffmengenanteil von Kohlenstoff in den zweiten Schichten 2 nicht mehr als 10 %, vorzugsweise nicht mehr als 5 % und besonders bevorzugt nicht mehr als 3 %. Durch die Zugabe von Kohlenstoff zum Grundmaterial Bor erhöht sich die elektrische Leitfähigkeit der zweiten Schichten 2 und ermöglicht vorteilhaft die Herstellung mittels DC-Magnetronsputtern. Das DC-Magnetronsputtern kann vorteilhaft bei Raumtemperatur erfolgen, insbesondere ohne Heizung des Sputtertargets. Eine unerwünschte Aufheizung des Substrats 6 während des Beschichtungsprozesses kann auf diese Weise vermieden werden. Hieraus resultieren die Vorteile, dass eine hohe Genauigkeit der Schichtdicken und eine gute Reproduzierbarkeit erreicht werden.

Weiterhin ist die Reflektivität der Schichtenfolge 4 größer, als wenn für die zweiten Schichten 2 Borcarbid (B₄C) verwendet würde. Zur Erzielung einer guten elektrischen Leitfähigkeit der zweiten Schichten 2 kann es vorteilhaft sein, wenn der Stoffmengenanteil von Kohlenstoff mindestens 0,1 %, bevorzugt mindestens 1 % oder besonders bevorzugt mindestens 2 % beträgt.

Es ist möglich, dass der Multilayer-Spiegel 10 an der vom Substrat 6 abgewandten Seite mindestens eine Deckschicht aufweist (nicht dargestellt), welche ein anderes Material und/oder eine andere Schichtdicke als die ersten Schichten 1 und zweiten Schichten 2 aufweisen kann. Eine solche Deckschicht kann beispielsweise dazu vorgesehen sein, die Beständigkeit des Multilayer-Spiegels 10 gegenüber Oxidation und/oder auftreffenden Ionen zu verbessern, insbesondere bei der Verwendung in der Nähe einer EUV-Strahlungsquelle. Geeignete Deckschichtmaterialien sind insbesondere Oxide, Nitride oder Karbide, beispielsweise Oxide, Nitride oder Carbide von La, Ce, U oder Th.

Bei der Herstellung des Multilayer-Spiegels 10 wird vorzugsweise die gesamte Schichtenfolge 5 mittels DC-Magnetronsputtern abgeschieden. Figur 2 zeigt rein schematisch den Sputtervorgang in einer DC-Magnetronsputteranlage 20. Das Substrat 6 wird bei dem Beschichtungsvorgang auf einem Substrathalter 23 angeordnet, der vorzugsweise in lateraler Richtung beweglich ist und so zum Aufbringen verschiedener Schichtmaterialien unter verschiedene Sputtertargets 21, 22 fahrbar ist. Zwischen dem Substrathalter 23, der als Anode fungiert, und den Sputtertargets 21, 22, die als Kathode fungieren, liegt beim Sputtervorgang eine Gleichspannung 25 an. Die DC-Magnetronsputteranlage 20 weist weiterhin einen Gaseinlass für das Sputtergas, vorzugsweise Argon, sowie eine Hochvakuumpumpe auf (nicht dargestellt). Über den Sputtertargets 21, 22 ist ein Magnetron 24 zur Erzeugung eines Magnetfelds angeordnet. Zusätzlich zu den beispielhaft dargestellten zwei Sputtertargets 21, 22 kann mindestens ein weiteres Sputtertarget vorgesehen sein, beispielsweise zur Herstellung von Barriereschichten aus einem dritten Material. Zum Aufbringen der zweiten Schichten 2 wird ein Sputtertarget 22 verwendet, das mit Kohlenstoff dotiertes Bor aufweist. Das Sputtertarget 22 kann insbesondere Bor mit einem Stoffmengenanteil von Kohlenstoff von nicht mehr als 10 %, vorzugsweise nicht mehr als 5 % und besonders bevorzugt von nicht mehr als 3 % aufweisen. Beispielsweise kann der Stoffmengenanteil von Kohlenstoff 2 % betragen.

Die Fremdatome aus Kohlenstoff werden durch Verwendung des Sputtertargets 22, das zusätzlich zu Bor die Fremdatome aus Kohlenstoff in dem gewünschten Stoffmengenanteil enthält, bereits bei der Herstellung in die zweiten Schichten 2 eingebracht. Auf diese Weise wird erreicht, dass das Material Kohlenstoff über die gesamten Schichtdicken der zweiten Schichten 2 verteilt ist. Insbesondere kann der Stoffmengenanteil von Kohlenstoff in den zweiten Schichten 2 abgesehen von eventuellen diffusionsbedingten Abweichungen an den Grenzflächen im Wesentlichen konstant sein.

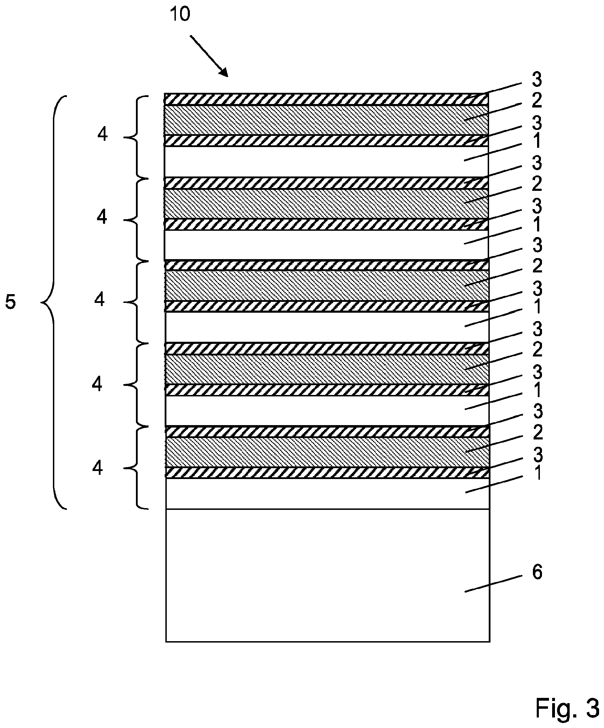

In Figur 3 ist ein weiteres Ausführungsbeispiel des Multilayer-Spiegels 10 dargestellt. Dieses entspricht im Wesentlichen dem ersten Ausführungsbeispiel, wobei aber zusätzlich an den Grenzflächen zwischen den ersten Schichten 1 und den zweiten Schichten 2 jeweils eine dünne Barriereschicht 3 eingefügt ist. Bei dem Ausführungsbeispiel der Figur 3 ist an allen Grenzflächen eine Barriereschicht 3 eingefügt, und zwar unabhängig davon, ob in Wachstumsrichtung eine erste Schicht 1 auf eine zweite Schicht 2 oder umgekehrt eine zweite Schicht 2 auf eine erste Schicht 1 folgt. Als Schichtpaar 4 in der Schichtenfolge ist in diesem Fall ein Paar aus einer ersten Schicht 1 und einer zweiten Schicht 2 einschließlich der dazwischen angeordneten Barriereschichten 3 anzusehen. Bei diesem Ausführungsbeispiel weist also eine Periode des Multilayer-Spiegels 10 jeweils vier Teilschichten auf.

Alternativ wäre es aber auch möglich, dass die Barriereschichten 3 jeweils nur an einer der Grenzflächen angeordnet sind, an denen Wachstumsrichtung eine erste Schicht 1 auf eine zweite Schicht 2 folgt oder umgekehrt. In diesem Fall würde eine Periode des Multilayer-Spiegels 10 drei Teilschichten aufweisen.

Die Barriereschichten 3 sind vorzugsweise nur zwischen 0,1 nm und 1,0 nm dick. Besonders geeignete Materialien für die Barriereschichten sind Kohlenstoff (C) und Borcarbid (B₄C). Es hat sich herausgestellt, dass durch das Einfügen der dünnen Barriereschichten 3 zwischen den ersten Schichten 1 und den zweiten Schichten 2 die Reflektivität des Multilayer-Spiegels 10 noch weiter erhöht werden kann. Es ist zu vermuten, dass sich durch das Einfügen der dünnen Barriereschichten 3 glattere Grenzflächen in der Schichtenfolge 5 ausbilden, welche sich positiv auf die Reflektivität der Schichtenfolge 5 auswirken.

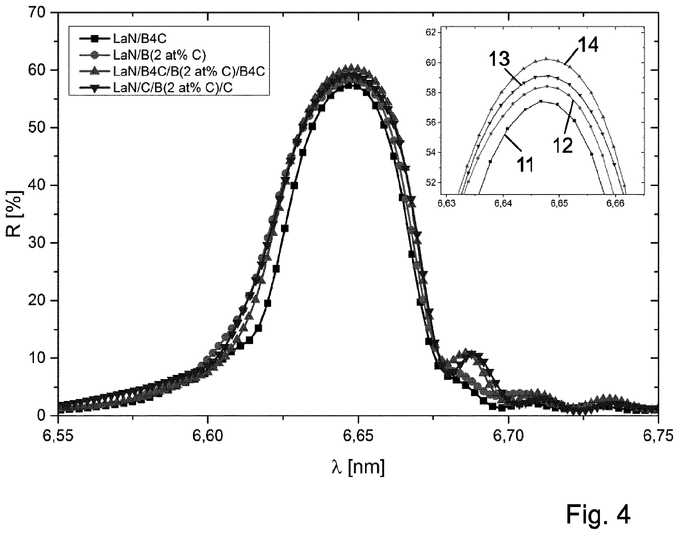

In Figur 4 ist die gemessene Reflexion R für s-polarisierte Strahlung bei 10° Einfallswinkel für drei Ausführungsbeispiele der Multilayer-Spiegel und ein nicht erfindungsgemäßes Vergleichsbeispiel dargestellt. In der eingefügten Ausschnittsvergrößerung ist der Bereich um das Reflexionsmaximum vergrößert dargestellt, um die Unterschiede in der maximalen Reflektivität zu verdeutlichen. Die Messungen sind am EUV-Reflektometer der PTB Berlin durchgeführt worden.

Die Reflexionskurve 11 zeigt die gemessene Reflektivität R eines nicht erfindungsgemäßen Vergleichsbeispiels eines Multilayer-Spiegels mit 250 Schichtpaaren, die aus abwechselnden ersten Schichten aus LaN und zweiten Schichten aus B₄C bestehen, in Abhängigkeit der Wellenlänge λ. Die gemessene Reflektivität im Maximum beträgt 57,8%. Die Reflexionskurve 12 zeigt die gemessene Reflektivität eines Ausführungsbeispiels eines Multilayer-Spiegels mit 250 Schichtpaaren, die aus abwechselnden ersten Schichten aus LaN und zweiten Schichten aus mit Kohlenstoff dotierten Bor bestehen, wobei der Stoffmengenanteil von Kohlenstoff 2% beträgt. Es zeigt sich, dass die gemessene Reflektivität im Maximum mit 58,4% größer ist als bei dem Vergleichsbeispiel der Reflexionskurve 11.

Die Reflexionskurve 13 zeigt die gemessene Reflektivität eines weiteren Ausführungsbeispiels eines Multilayer-Spiegels mit 250 Schichtpaaren, die abwechselnde erste Schichten aus LaN und zweite Schichten aus mit Kohlenstoff dotierten Bor aufweisen, wobei der Stoffmengenanteil von Kohlenstoff 2% beträgt. Bei diesem Ausführungsbeispiel sind zusätzlich an allen Grenzflächen zwischen ersten Schichten und zweiten Schichten Barriereschichten aus Kohlenstoff (C) eingefügt. Die gemessene Reflektivität im Maximum ist mit 59,1% noch größer ist als bei dem Ausführungsbeispiel der Reflexionskurve 12.

Die Reflexionskurve 14 zeigt die gemessene Reflektivität eines weiteren Ausführungsbeispiels eines Multilayer-Spiegels mit 250 Schichtpaaren, die abwechselnde erste Schichten aus LaN und zweiten Schichten aus mit Kohlenstoff dotierten Bor aufweisen, wobei der Stoffmengenanteil von Kohlenstoff 2% beträgt. Bei diesem Ausführungsbeispiel sind zusätzlich an allen Grenzflächen zwischen ersten Schichten und zweiten Schichten Barriereschichten aus Borcarbid (B₄C) eingefügt. Die gemessene Reflektivität im Maximum ist mit 60,6% noch größer als bei dem Ausführungsbeispiel der Kurve 13.

Die Erfindung ist nicht durch die Beschreibung anhand der Ausführungsbeispiele beschränkt.

### Bezugszeichenliste

- 1: erste Schicht
- 2: zweite Schicht
- 3: Barriereschicht
- 4: Schichtpaar
- 5: Schichtenfolge
- 6: Substrat
- 10: Multilayer-Spiegel
- 11: Reflexionskurve
- 12: Reflexionskurve
- 13: Reflexionskurve
- 14: Reflexionskurve
- 20: DC-Magnetronsputteranlage
- 21: erstes Sputtertarget
- 22: zweites Sputtertarget
- 23: Substrathalter
- 24: Magnetron
- 25: Gleichspannung

## Patentansprüche

1. Multilayer-Spiegel (10) für EUV-Strahlung, der eine auf einem Substrat (6) angeordnete Schichtenfolge (5) mit einer Vielzahl von abwechselnden ersten Schichten (1) und zweiten Schichten (2) aufweist, wobei die ersten Schichten (1) Lanthan oder eine Lanthanverbindung aufweisen, und die zweiten Schichten (2) Bor aufweisen, **dadurch gekennzeichnet, dass** die zweiten Schichten (2) mit Kohlenstoff dotiert sind, wobei der Stoffmengenanteil von Kohlenstoff in den zweiten Schichten (2) 10 % oder weniger beträgt.

2. Multilayer-Spiegel nach Anspruch 1,
wobei der Stoffmengenanteil von Kohlenstoff in den zweiten Schichten (2) 5 % oder weniger beträgt.

3. Multilayer-Spiegel nach einem der vorhergehenden Ansprüche,
wobei der Stoffmengenanteil von Kohlenstoff in den zweiten Schichten (2) 3 % oder weniger beträgt.

4. Multilayer-Spiegel nach einem der vorhergehenden Ansprüche,
wobei die Lanthanverbindung ein Lanthannitrid, ein Lanthanoxid oder ein Lanthancarbid ist.

5. Multilayer-Spiegel nach einem der vorhergehenden Ansprüche,
wobei die ersten Schichten (1) und die zweiten Schichten (2) jeweils eine Dicke zwischen 1 nm und 3 nm aufweisen.

6. Multilayer-Spiegel nach einem der vorhergehenden Ansprüche,
wobei an Grenzflächen zwischen den ersten Schichten (1) und den zweiten Schichten (2) dünne Barriereschichten (3) angeordnet sind, die B₄C oder C aufweisen und nicht mehr als 1,0 nm dick sind.

7. Multilayer-Spiegel nach einem der vorhergehenden Ansprüche,
wobei die Schichtenfolge (5) eine periodische Schichtenfolge ist und die Periodendicke zwischen 3 nm und 4 nm beträgt.

8. Multilayer-Spiegel nach einem der vorhergehenden Ansprüche,
wobei die Schichtenfolge (5) zwischen 100 und 400 Schichtpaare (4) mit jeweils einer der ersten Schichten (1) und einer der zweiten Schichten (2) aufweist.

9. Verfahren zur Herstellung eines Multilayer-Spiegels (10) für den EUV-Spektralbereich,
bei dem auf einem Substrat (6) abwechselnd erste Schichten (1), die Lanthan oder eine Lanthanverbindung aufweisen, und zweite Schichten (2), die Bor aufweisen, abgeschieden werden, wobei die zweiten Schichten (2) mit Kohlenstoff dotiert sind, und wobei der Stoffmengenanteil von Kohlenstoff in den zweiten Schichten (2) 10 % oder weniger beträgt.

10. Verfahren nach Anspruch 9,
wobei die ersten Schichten (1) und die zweiten Schichten (2) durch DC-Magnetronsputtern abgeschieden werden.

11. Verfahren nach Anspruch 10,
wobei beim DC-Magnetronsputtern der zweiten Schichten (2) ein Sputtertarget (22) verwendet wird, das mit Kohlenstoff dotiertes Bor aufweist.

12. Verfahren nach Anspruch 11,
wobei der Kohlenstoff in dem Sputtertarget (22) einen Stoffmengenanteil von 10 % oder weniger aufweist.

13. Verfahren nach einem der Ansprüche 10 bis 12,
wobei das DC-Magnetronsputtern bei Raumtemperatur erfolgt.

## Claims

1. A multilayer mirror (10) for EUV radiation comprising a layer sequence (5) disposed on a substrate (6) and having a plurality of alternating first layers (1) and second layers (2), the first layers (1) comprising lanthanum or a lanthanum compound and the second layers (2) comprising boron
**characterised in that** the second layers (2) are doped with carbon, the substance amount fraction of carbon in the second layers (2) being 10% or less.

2. The multilayer mirror according to claim 1,
wherein the substance amount fraction of carbon in the second layers (2) is 5% or less.

3. The multilayer mirror according to any one of the preceding claims,
wherein the substance amount fraction of carbon in the second layers (2) is 3% or less.

4. The multilayer mirror according to any one of the preceding claims,
wherein the lanthanum compound is a lanthanum nitride, a lanthanum oxide or a lanthanum carbide.

5. The multilayer mirror according to any one of the preceding claims,
wherein the first layers (1) and the second layers (2) each have a thickness between 1 nm and 3 nm.

6. The multilayer mirror according to any one of the preceding claims,
wherein thin barrier layers (3) are arranged at interfaces between the first layers (1) and the second layers (2), which barrier layers (3) comprise B₄C or C and are not more than 1.0 nm thick.

7. The multilayer mirror according to any one of the preceding claims,
wherein the layer sequence (5) is a periodic layer sequence and the periodic thickness is between 3 nm and 4 nm.

8. The multilayer mirror according to any one of the preceding claims,
wherein the layer sequence (5) comprises between 100 and 400 layer pairs (4) each comprising one of the first layers (1) and one of the second layers (2).

9. A method of producing a multilayer mirror (10) for the EUV spectral range,
in which first layers (1) comprising lanthanum or a lanthanum compound and second layers (2) comprising boron are deposited alternately on a substrate (6), the second layers (2) being doped with carbon, and the substance amount fraction of carbon in the second layers (2) being 10% or less.

10. The mehtod according to claim 9,
wherein the first layers (1) and the second layers (2) are deposited by DC magnetron sputtering.

11. The method according to claim 10,
wherein the DC magnetron sputtering of the second layers (2) uses a sputtering target (22) comprising carbon doped boron.

12. The method of claim 11,
wherein the carbon in the sputtering target (22) has a substance amount fraction of 10% or less.

13. The method according to any one of claims 10 to 12,
wherein the DC magnetron sputtering is performed at room temperature.

## Revendications

1. Un miroir multicouche (10) pour rayonnement EUV comprenant une séquence de couches (5) disposée sur un substrat (6) et ayant une pluralité de premières couches (1) et de secondes couches (2) alternées, les premières couches (1) comprenant du lanthane ou un composé de lanthane, et les secondes couches (2) comprenant du bore,
**caractérisé en ce que** les secondes couches (2) sont dopées avec du carbone, la teneur molaire en carbone dans les secondes couches (2) étant de 10% ou moins.

2. Le miroir multicouche selon la revendication 1,
dans lequel la teneur molaire en carbone dans les secondes couches (2) est de 5 % ou moins.

3. Le miroir multicouche selon l'une quelconque des revendications précédentes,
dans lequel la teneur molaire en carbone dans les secondes couches (2) est de 3 % ou moins.

4. Le miroir multicouche selon l'une quelconque des revendications précédentes,
dans lequel le composé de lanthane est un nitrure de lanthane, un oxyde de lanthane ou un carbure de lanthane.

5. Le miroir multicouche selon l'une quelconque des revendications précédentes,
dans lequel les premières couches (1) et les secondes couches (2) ont chacune une épaisseur comprise entre 1 nm et 3 nm.

6. Le miroir multicouche selon l'une quelconque des revendications précédentes,
dans lequel de minces couches de barrière (3) sont disposées aux interfaces entre les premières couches (1) et les secondes couches (2), lesquelles couches de barrière (3) comprennent du B₄C ou du C et n'ont pas une épaisseur supérieure à 1,0 nm.

7. Le miroir multicouche selon l'une quelconque des revendications précédentes,
dans lequel la séquence de couches (5) est une séquence de couches périodique et l'épaisseur périodique est comprise entre 3 nm et 4 nm.

8. Le miroir multicouche selon l'une quelconque des revendications précédentes,
dans lequel la séquence de couches (5) comprend entre 100 et 400 paires de couches (4) comprenant chacune une des premières couches (1) et une des secondes couches (2) .

9. Une méthode de fabrication d'un miroir multicouche (10) pour la gamme spectrale EUV,
dans lequel des premières couches (1) contenant du lanthane ou un composé du lanthane et des deuxièmes couches (2) contenant du bore sont déposées en alternance sur un substrat (6), les deuxièmes couches (2) étant dopées au carbone et la fraction molaire de carbone dans les deuxièmes couches (2) étant de 10 % ou moins.

10. La méthode selon la revendication 9,
dans laquelle les premières couches (1) et les secondes couches (2) sont déposées par pulvérisation magnétron à courant continu.

11. La méthode selon la revendication 10,
dans laquelle la pulvérisation magnétron à courant continu des secondes couches (2) utilise une cible de pulvérisation (22) comprenant du bore dopé au carbone.

12. La méthode de la revendication 11,
dans laquelle le carbone dans la cible de pulvérisation (22) a une fraction molaire de 10 % ou moins.

13. La méthode selon l'une quelconque des revendications 10 à 12,
dans laquelle la pulvérisation magnétron à courant continu est effectuée à température ambiante.
